## Europäisches Patentamt
## European Patent Office
## Office européen des brevets

(11) Veröffentlichungsnummer: **0 015 965**
**B1**

(12) **EUROPÄISCHE PATENTSCHRIFT**

(45) Veröffentlichungstag der Patentschrift:
24.03.82

(21) Anmeldenummer: **79900449.4**

(22) Anmeldetag: **03.05.79**

(86) Internationale Anmeldenummer:
**PCT/CH 79/00065**

(87) Internationale Veröffentlichungsnummer:
**WO 79/01028 (29.11.79 Gazette 79/24)**

(51) Int. Cl.³: **G 08 B 13/08,** H 01 H 3/16,
E 05 G 1/10

(54) **Vorrichtung zur Kontrolle der Schliessstellung einer Flügeltüre.**

(30) Priorität: **03.05.78 CH 4861/78**

(43) Veröffentlichungstag der Anmeldung:
**01.10.80 Patentblatt 80/20**

(45) Bekanntmachung des Hinweises auf die Patenterteilung:
**24.03.82 Patentblatt 82/12**

(84) Benannte Vertragsstaaten:
**FR**

(56) Entgegenhaltungen:
**AT-B-293 222
AU-B-13 005/70
GB-A-1 333 034
US-A-3 840 715
US-A-3 838 234
US-A-3 973 357
US-A-4 074 246**

(73) Patentinhaber: **BAUER KASSENFABRIK AG,
Flughofstrasse 40, CH-8153 Rümlang (CH)**

(72) Erfinder: **SPAHNI, Kurt, Alt Bachs, CH-8164 Bachs (CH)**
Erfinder: **BUCHER, Walter, Bahnhofstrasse 21b,
CH-8864 Reichenburg (CH)**

(74) Vertreter: **Siebert, Rolf, c/o Dr. A.R. Egli & Co.
Horneggstrasse 4, CH-8008 Zürich (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Vorrichtung zur Kontrolle der Schliessstellung einer Flügeltüre

Die Erfindung betrifft eine Vorrichtung zur Kontrolle der Schliessstellung einer Flügeltüre, bestehend aus einer teilweise an der Türzarge und teilweise an der Flügeltüre selber angeordneten mehrteiligen Schalteinrichtung, welche ein die Schliessstellung der Türe anzeigendes elektrisches Signal abgibt.

Es ist bereits bekannt, für eine solche Kontrolle eine Schalteinrichtung vorzusehen, welche in der geschlossenen Stellung ein akustisches oder optisches Meldesignal auslöst. Bei einer bekannten Anordnung (GB-A 1 333 034) ist diese Schalteinrichtung in Vertiefungen in einem der Türscharniere eingebaut und wird durch die beim Schliessen bzw. Öffnen der Türe erfolgende Drehung des Scharnierstiftes um seine Längsachse betätigt, indem der letztere in der geschlossenen Stellung einen von der Kreisform abweichenden Querschnitt aufweist, sodass sich ein Abtaststift verschieben und das Signal auslösen kann. Das betreffende Scharnier wird dann so mit dem Türblatt verschraubt, dass die Vertiefungen gegen das letztere zu liegen kommen, so dass die Schalteinrichtung von aussen her vorerst unzugänglich ist.

Das Unterbringen von Schalteinrichtungen in Türscharnieren ist jedoch nicht unbedingt die zweckmässigste Lösung, denn auch noch so kleine Einrichtungen, die meist einen Mikroschalter umfassen, weisen eine gewisse Dicke auf, während andererseits die Scharnierteile auch bei schweren Türen aus relativ dünnem Plattenmaterial bestehen. Die erwähnte Anordnung bringt es also mit sich, dass für das Türscharnier erheblich dickeres Material benötigt wird, um die Vertiefungen anbringen zu können. Weil es ausserdem üblich ist, dass alle Scharniere aus demselben Material hergestellt werden, wird dieses auch für die übrigen Scharniere, die keine Einrichtung aufweisen, verwendet, obwohl dort dünneres Material ohne weiteres möglich wäre.

Scharniere sind jedoch auch deswegen kein idealer Ort für solche Schalteinrichtungen, weil es kein Problem bedeutet, unbemerkt dasjenige Scharnier mit der Schalteinrichtung von der Türe abzuschrauben und die Einrichtung so abzuändern, dass das Signal für den geschlossenen Zustand ausgelöst wird, obwohl die Türe noch offen steht. Dass bei Gefängnistüren solche Meldungen an die Überwachungszentrale unbedingt vermieden werden müssen, liegt auf der Hand.

Zweck der Erfindung ist es daher, solche Nachteile zu vermeiden, und ihr liegt die Aufgabe zugrunde, eine Vorrichtung der eingangserwähnten Art zu schaffen, welche für unbefugte Personen unzugänglich ist. Eine solche Vorrichtung ist erfindungsgemäss dadurch gekennzeichnet, dass alle Teile der Schalteinrichtung durch ein gemeinsames Gehäuse unzugänglich abschliessbar sind, welches aus einem mit der Flügeltüre unlösbar verbundenen Basisteil und einer verriegelbar auf diesen aufgesetzten Gehäusekappe besteht, die durch ein im Innern des Gehäuses angeordnetes und mit der Gehäusekappe von innen her zerstörungsfrei lösbar verbundenes Sicherheitsschloss mit dem Gehäusebasisteil verriegelt und dadurch gegen Abheben von diesem seitens einer unbefugten Person gesichert ist, und dass das Gehäusebasisteil einen von der Gehäusekappe überdeckten Verriegelungsanschlag für den von ihr gleichfalls überdeckten Schlossriegel aufweist, wobei der Schalter und sein Betätigungsorgan erst und nur nach Abheben der entriegelten Gehäusekappe vom Gehäusebasisteil zugänglich werden.

Hierbei kann eine bevorzugte Ausführungsform der Schalteinrichtung darin bestehen, dass das Schaltorgan aus einer Exzenterscheibe besteht, die an einem mit der Zarge zerstörungsfrei unlösbar verbundenen Randzapfen angebracht ist, und dass ein bewegbarer Schalterteil des Schalters mit einer Rolle versehen ist, die beim Schwenken der Türe auf dem Umfang der Exzenterscheibe abläuft.

Ferner kann eine Ausführungsform der Schalteinrichtung darin bestehen, dass der ein Drehlager für den Gehäusebasisteil bildende Bandzapfen eine über die Scharnierseite der Türe hinausragende Partie des Gehäusebasisteils durchsetzt und die Exzenterscheibe an einer in dem Gehäuse hineinragenden Zapfenpartie des Bandzapfens zerstörungsfrei lösbar befestigt ist, dass der Schalter mit einer unteren Partie des Gehäusebasisteils zerstörungsfrei lösbar verbunden ist und dass der hohle Bandzapfen zugleich zur Aufnahme der aus dem Innern der Zarge herausgeführten Schalterkabel und zu deren Zuführung zum Schalter dient.

Weiterhin kann vorzugsweise die zu benutzende Ausführung dieser Schaltereinrichtung darin bestehen, dass der im Querschnitt im wesentlichen U-förmige Gehäusebasisteil aus einer rechtwinklig abgewinkelten Trägerplatte und einer mit dieser zerstörungsfrei unlösbar verbundenen, sich horizontal erstreckenden Bandplatte besteht, und dass durch einen horizontal verlaufenden Schenkel der Trägerplatte ein Auflageanschlag für die vom Gehäusebasisteil vertikal nach oben abhebbare Gehäusekappe gebildet wird und ein mit seinem horizontalen Schenkel als Verriegelungsanschlag dienender Anschlagwinkel mit dem nach unten ragenden Schenkel der Trägerplatte zerstörungsfrei unlösbar verbunden ist.

Auch kann eine bevorzugte Ausführungsform der Schalteinrichtung darin bestehen, dass ein unterer Teil des Bandzapfens durch einen diesen von der Zarge distanzierenden Zapfenschuh mit der Zarge zerstörungsfrei unlösbar verbunden ist und ein mit dieser zerstörungsfrei unlösbar verbundenes Kabeldurchführungsrohr die Zargenvorderwand, den Zapfenschuh und eine zargenseitige Wandpartie des unteren Bandzapfenteiles durchsetzt.

Schliesslich kann eine vorzugsweise Ausführungsform der Schalteinrichtung darin bestehen, dass der vertikal nach unten ragende Schenkel der abgewinkelten Trägerplatte mit einer sich horizontal erstreckenden fensterartigen Ausnehmung und der Anschlagwinkel an seinem horizontalen Anschlagschenkel mit Durchgangsöffnungen für die Kabeldurchführung zum Schalter hin versehen sind.

In der Zeichnung ist ein Ausführungsbeispiel der Schalteinrichtung nach der Erfindung, das auch deren Wirkungsweise veranschaulicht, schematisch dargestellt. Es zeigen:

Fig. 1 eine Schalteinrichtung bei geschlossener Türe, in einem Horizontalschnitt nach der Linie I-I der Fig. 2,

Fig. 2 die Schalteinrichtung nach Fig. 1, in einem Vertikalschnitt nach der Linie II-II der Fig. 1,

Fig. 3 die Schalteinrichtung nach Fig. 1 bei offenstehender Türe, im gleichen Horizontalschnitt wie in Fig. 1, und

Fig. 4 die Schalteinrichtung nach Fig. 1 und 2 bei geschlossener Türe, in einem Vertikalschnitt nach der Linie IV-IV der Fig. 2.

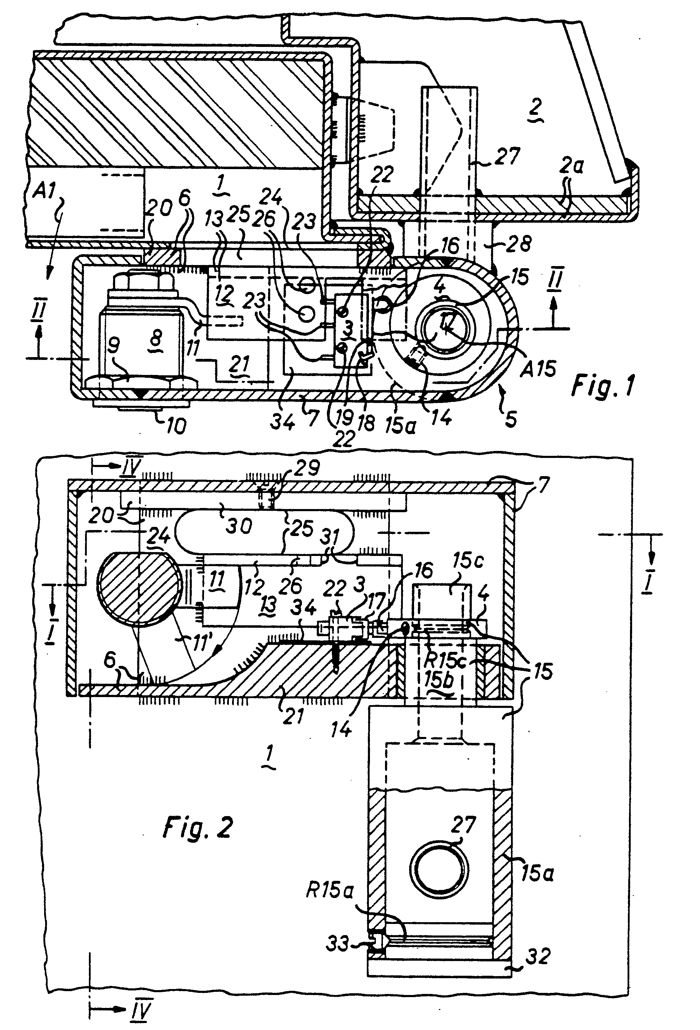

In Fig. 1 ist eine Flügeltüre mit 1 und die zugehörige Türzarge mit 2 bezeichnet. Die Türe 1, die mittels mehrerer, der grösseren Deutlichkeit wegen in Fig. 1 nicht dargestellter Scharniere an der Zarge 2 im Sinne des Drehrichtungspfeiles A1 nach aussen schwenkbar gelagert ist und sich in Fig. 1 gerade in ihrer Schliessstellung befindet, ist hier z.B. eine Gefängniszellentüre, wobei die Zarge 2 in der flurseitigen Zellenwand eingelassen und mit dieser fest verankert ist. Ein an der Türe 1 angebrachter Signalschalter 3 und ein zu dessen Betätigung an der Zarge 2 vorgesehenes Schaltorgan 4 sind in einem gemeinsamen Gehäuse 5 untergebracht, das im wesentlichen aus einem an der Türe 1 angebrachten Gehäusebasisteil 6 und einer darauf aufgesetzten, deckelartigen Gehäusekappe 7 besteht (vgl. auch Fig. 2 u. 4). Das Gehäusebasisteil 6 ist an mehreren Stellen an der Frontseite der Türe 1 angeschweisst, d.h. es kann nicht ohne Beschädigung bzw. Zerstörung von Teilen von der Türe 1 entfernt werden. Eine derartige Verbindung von Teilen, die im folgenden kurz als «zerstörungsfrei unlösbar» bezeichnet werden, ist für den Schutz der Schalteinrichtung gegen irgendwelche Manipulationen seitens einer unbefugten Person, namentlich eines Häftlings, von grundsätzlicher Bedeutung. Innerhalb des Gehäuses 5 ist auch ein Sicherheitsschloss 8 untergebracht, das hier als Zylinderschloss ausgebildet ist und zu einer inneren Verriegelung der Gehäusekappe 7 mit dem Gehäusebasisteil 6 dient, wodurch ein unbefugtes Abheben der Gehäusekappe 7 vom Gehäusebasisteil 6 verhindert werden soll. Da dank der verriegelten Gehäusekappe 7 das Zylinderschloss 8 unbefugten Personen nicht zugänglich ist, kann es mittels einer Sechskantschraubmutter 9 zerstörungsfrei lösbar mit der Gehäusekappe 7 verbunden sein. Der Rotor 10 des Zylinderschlosses 8 ist frontseitig mit einem Schlüsselkanal zum Einführen eines passenden Flachschlüssels und an seinem hinteren Ende mit einem Schlossriegel 11 versehen, der in seiner Verriegelungsdrehlage von unten her an einem horizontal verlaufenden Schenkel 12 eines am Gehäusebasisteil 6 angeschweissten Anschlagwinkels 13 anliegt und dadurch ein Abheben der Gehäusekappe 7 vom Gehäusebasisteil 6 vertikal nach oben verhindert.

Das Schaltorgan 4 zur Betätigung des Signalschalters 3 ist hier als Exzenterscheibe ausgebildet und mittels einer Klemmschraube 14 an einem sich vertikal erstreckenden Bandzapfen 15 gegenüber diesem unverdrehbar, aber lösbar befestigt, der seinerseits an der Türe 1 angeschweisst ist. Die Achse A15 des Bandzapfens 15 fällt mit der Schwenkachse der Flügeltüre 1 zusammen, fluchtet also mit den Türscharnierachsen. Eine zum Schalter 3 gehörende Rolle 16 läuft beim Schwenken der Türe 1 auf dem Umfang der Exzenterscheibe 4 ab und ist am freien Ende eines Schalterhebels 17 drehbar gelagert, der seinerseits im Schalter 3 bei 18 schwenkbar gelagert ist. Der Schalterhebel 17 steht in ständiger Wirkverbindung mit einem Schaltkontaktstift 19, der den eigentlichen Schaltvorgang bewirkt, d.h. den Stromkreis zur Auslösung eines Meldesignals schliesst. In Fig. 1, die die Türe 1 in ihrer Schliessstellung zeigt, ist der Signalstromkreis geschlossen, d.h. der Schalterhebel 17 ist beim Zuschwenken der Türe 1 von der stationären Exzenterscheibe 4 über die Rolle 16 gegen den Druck einer in Fig. 1 nicht sichtbaren Feder gegen den Schaltkontaktstift 19 gedrückt worden, wodurch der Stromkreis geschlossen worden ist. Eine besondere Einrichtung sorgt dafür, dass der Signalstromkreis nach Abgabe eines Meldesignals von bestimmter Dauer wieder geöffnet wird, so dass der Signalton nach einiger Zeit wieder verstummt.

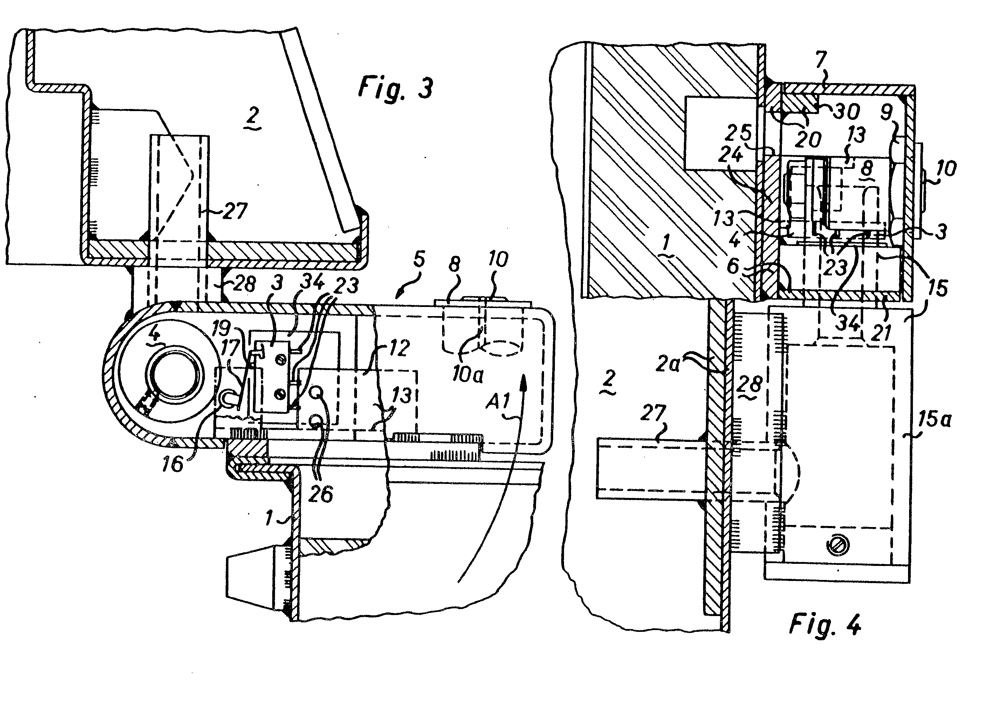

Das im Vertikalschnitt (vgl. Fig. 4) im wesentlichen U-förmige Gehäusebasisteil 6 besteht aus einer rechtwinklig abgewinkelten Trägerplatte 20 und einer an dieser angeschweissten, sich horizontal erstreckenden Bandplatte 21 (vgl. auch Fig. 2 und 4). Der Schalter 3, der mittels zweier Befestigungsschrauben 22 an der Bandplatte 21 angeschraubt ist (vgl. auch Fig. 2), weist drei Kabelanschlüsse 23 auf, an denen die Kabel des Signalstromkreissystems angeschlossen sind. Der vertikal nach unten ragende Schenkel 24 der abgewinkelten Trägerplatte 20 weist eine fensterartige Ausnehmung 25 zur Durchführung der Kabel aus dem Innern der Türe 1 auf, während der horizontal verlaufende Schenkel 12 des an der Trägerplatte 20 angeschweissten Anschlagwinkels 13 mit zwei Durchgangsöffnungen 26 versehen ist, die zur Weiterführung von zwei dieser drei Kabel zu den beiden vom Anschlagwinkelschenkel 12 überdeckten Kabelanschlüssen 23 dienen.

Der zweimal abgesetzte Bandzapfen 15 ist hohlzylindrisch ausgebildet (vgl. Fig. 2) und dient gleichfalls zur Zuführung der Kabel aus dem Innern der Zarge 2 zum Schalter 3. Dazu ist auch ein Kabeldurchführungsrohr 27 vorgesehen, das an der Vorderwand 2a der Zarge 2 von hinten angeschweisst ist und diese sowie einen den Bandzapfen 15 von der Zarge 2 distanzierenden Zapfenschuh 28 und eine zargenseitige Wandpartie des unteren hohlzylindrischen Teils 15a des Bandzapfens 15 durchsetzt (vgl. auch Fig. 4). Der Zapfenschuh 28 ist an der Vorderwand 2a der Zarge 2 angeschweisst, und der untere Teil 15a des Bandzapfens 15 ist wiederum am Zapfenschuh 28 angeschweisst (vgl. auch Fig. 4).

Aus Fig. 2 geht hervor, dass und wie die Gehäusekappe 7 vom Gehäusebasisteil 6 entriegelt wird, wenn eine dazu befugte Person mittels eines zum Zylinderschloss 8 passenden Schlüssels den Zylinderschlossrotor und damit zugleich auch den Schlossriegel 11 aus der Verriegelungsdrehlage in die mit 11' angedeutete Entriegelungsdrehlage verdreht. Bei diesem Entriegelungsvorgang kommt nämlich der abwärtsschwenkende Schlossriegel 11 vom horizontalen Anschlagschenkel 12 des Anschlagwinkels 13 frei, wonach die deckelartige Gehäusekappe 7 von der zum Gehäusebasisteil 6 gehörenden Trägerplatte 20 vertikal nach oben abgehoben werden kann, wenn zuvor eine nur der Fixierung der Kappe 7 dienende Befestigungsschraube 29 aus dem als Auflage für die Gehäusekappe 7 dienenden horizontalen Schenkel 30 der abgewinkelten Trägerplatte 20 herausgeschraubt wurde. Der an der Trägerplatte 20 angeschweisste Anschlagwinkel 13 ist an seinem horizontalen Anschlagschenkel 12 mit einer Aussparung 31 versehen, welche die Zugänglichkeit zu den beiden Schalterbefestigungsschrauben 22 gewährleistet. Dies geht bereits aus Fig. 1 hervor, wo der rechts befindliche Lappen des horizontalen Anschlagschenkels 12 abgebrochen dargestellt ist, um den darunter befindlichen Schalterhebel 17 mit seiner Exzenterrolle 16 in der Zeichnung erscheinen zu lassen. Ferner geht aus Fig. 2 deutlich hervor, dass und wie die abgewinkelte Trägerplatte 20 und die an dieser unten angeschweisste Bandplatte 21 das Gehäusebasisteil 6 bilden, das durch Anschweissen der Trägerplatte 20 an der Türe 1 zerstörungsfrei unlösbar mit dieser verbunden ist, und dass die Gehäusekappe 7 nach Form und Abmessungen dem sie aufnehmenden Gehäusebasisteil 6 angepasst ist (vgl. auch Fig. 4). Ferner ist aus Fig. 2 der zweimal abgesetzte zylindrische Bandzapfen 15 ersichtlich, in dessen unteren hohlzylindrischen Teil 15a das Kabeldurchführungsrohr 27 einmündet, dessen mittlerer Zapfenteil 15b die Bandplatte 21 durchsetzt und an dessen oberem Zapfenteil 15c, der den kleinsten Zapfendurchmesser aufweist, die Exzenterscheibe 4 mittels der Klemmschraube 14, die in eine Ringnut R15c des Zapfenteils 15c eingreift, lösbar befestigt ist. Der Bandzapfen 15, der von unten bis oben durchgehend hohlzylindrisch ist, um die durch das Kabeldurchführungsrohr 27 in ihn eingeführten Kabel durch den Bandzapfen 15 hindurch dem Schalter 3 zuführen zu können, ist unten durch einen Zapfendeckel 32 verschlossen, der mittels einer in eine Ringnut R15a des unteren Zapfenteils 15a eingreifenden Klemmschraube 33 am Bandzapfen 15 befestigt ist. Eine rechtwinklige Montageplatte 34 (vgl. auch Fig. 1) gewährleistet durch die Wahl ihrer Dicke die richtige Höhenlage des Schalters 3 bzw. seiner Exzenterrolle 16.

In Fig. 3 ist die Türe 1 samt dem an ihr zerstörungsfrei unlösbar befestigten Gehäuse 5, in dessen Innern die Schalteinrichtung untergebracht ist, im Sinne des Drehrichtungspfeils A1 um 180° in ihre Öffnungsstellung geschwenkt dargestellt. Während der Schwenkbewegung der Flügeltüre 1 ist die auf der ortsfesten Exzenterscheibe 4 ablaufende Rolle 16 des Schalterhebels 17 vom Umfang der Exzenterscheibe 4 freigekommen, wobei und wodurch der nach aussen schwenkende Schalterhebel 17 es dem Schaltkontaktstift 19 ermöglicht hat, unter dem Druck seiner Stiftfeder aus dem Schaltergehäuse 3 in Fig. 3 nach links herauszutreten und dadurch den Signalstromkreis zu unterbrechen. Ferner lässt Fig. 3 wieder die etwa quadratische Montageplatte 34 für den Schalter 3, die drei Kabelanschlüsse 23 und die beiden Durchgangsöffnungen 26 des Anschlagschenkels 12 am Anschlagwinkel 13 erkennen. Die frontalen Stirnseiten des Zylinderschlosses 8 und seines mit dem Schlüsselkanal 10a versehenen Rotors oder Zylinderkerns 10 befinden sich bei offenstehender Türe 1 hinten.

Fig. 4 zeigt die Schalteinrichtung bei geschlossener Türe 1 in einem Vertikalschnitt. Der horizontal verlaufende Schenkel 30 der abgewinkelten Trägerplatte 20, der als Auflageanschlag für die Gehäusekappe 7 dient, besteht aus einer Leiste, die oberhalb des Kabeldurchführungsfensters 25 am vertikalen Plattenschenkel 24 der Trägerplatte 20 angeschweisst ist (vgl. auch Fig. 2). Aus Fig. 4 sind wieder das Zylinderschloss 8 mit Befestigungsmutter 9 und Rotor 10, der durch das Zylinderschloss 8 teilweise verdeckte Anschlagwinkel 13, die vom Schalter 3 teilweise verdeckte Exzenterscheibe 4, die am vertikalen Schenkel 24 der Trägerplatte 20 unten angeschweisste Bandplatte 21 sowie die drei Kabelanschlüsse 23 ersichtlich. Ferner ist aus Fig. 4 deutlich zu ersehen, dass und wie der Bandzapfen 15 durch den einerseits an der Vorderwand 2a der Zarge 2 und andererseits am Zapfenteil 15a angeschweissten Zapfenschuh 28 von der Zarge 2 distanziert und mit dieser zerstörungsfrei unlösbar verbunden ist. Auch geht aus Fig. 4 hervor, dass die Kabel aus dem Innern der Zarge 2 durch das an der Zargenvorderwand 2a von hinten angeschweisste Kabeldurchführungsrohr 27 und anschliessend durch den Hohlraum des hohlzylindrischen Bandzapfens 15 hindurch nach oben zum Schalter 3 bzw. seinen Kabelanschlüssen 23 geführt werden können.

**Patentansprüche**

1. Vorrichtung zur Kontrolle der Schliessstellung einer Flügeltüre (1), bestehend aus einer teilweise an der Türzarge (2) und teilweise an der Flügeltüre (1) selber angeordneten mehrteiligen Schalteinrichtung, welche ein die Schliessstellung der Türe (1) anzeigendes elektrisches Signal abgibt, dadurch gekennzeichnet, dass alle Teile (3, 4, 16, 17, 19, 23) der Schalteinrichtung durch ein gemeinsames Gehäuse (5) unzugänglich abschliessbar sind, welches aus einem mit der Flügeltüre (1) unlösbar verbundenen Basisteil (6) und einer verriegelbar auf diesen aufgesetzten Gehäusekappe (7) besteht, die durch ein im Innern des Gehäuses (5) angeordnetes und mit der Gehäusekappe (7) von innen her zerstörungsfrei lösbar verbundenes Sicherheitsschloss (8) mit dem Gehäusebasisteil (6) verriegelt und dadurch gegen Abheben von diesem seitens einer unbefugten Person gesichert ist, und dass das Gehäusebasisteil (6) einen von der Gehäusekappe (7) überdeckten Verriegelungsanschlag (12) für den von ihr gleichfalls überdeckten Schlossriegel (11) aufweist, wobei der Schalter (3) und sein Betätigungsorgan (4) erst und nur nach Abheben der entriegelten Gehäusekappe (7) vom Gehäusebasisteil (6) zugänglich werden.

2. Vorrichtung nach Anspruch 1, bei welcher ein Teil der Schalteinrichtung ein Schaltorgan (4) ist, dadurch gekennzeichnet, dass dieses Schaltorgan (4) aus einer Exzenterscheibe besteht, die an einem mit der Zarge (2) zerstörungsfrei unlösbar verbundenen Bandzapfen (15) angebracht ist, und dass ein bewegbarer Schalterteil (17) des Schalters (3) mit einer Rolle (16) versehen ist, die beim Schwenken der Türe (1) auf dem Umfang der Exzenterscheibe (4) abläuft.

3. Vorrichtung nach Anspruch 2, dadurch gekennzeichnet, dass der ein Drehlager (15b) für den Gehäusebasisteil (6) bildende Bandzapfen (15) eine über die Scharnierseite der Türe (1) hinausragende Partie des Gehäusebasisteils (6) durchsetzt und die Exzenterscheibe (4) an einer in das Gehäuse (5) hineinragenden Zapfenpartie (15c) des Bandzapfens (15) zerstörungsfrei lösbar befestigt ist, dass der Schalter (3) mit einer unteren Partie (21) des Gehäusebasisteils (6) zerstörungsfrei lösbar verbunden ist und dass der hohle Bandzapfen (15) zugleich zur Aufnahme der aus dem Innern der Zarge (2) herausgeführten Schalterkabel und zu deren Zuführung zum Schalter (3) dient.

4. Vorrichtung nach Anspruch 1, dadurch gekennzeichnet, dass der im Querschnitt im wesentlichen U-förmige Gehäusebasisteil (6) aus einer rechtwinklig abgewinkelten Trägerplatte (20) und einer mit dieser zerstörungsfrei unlösbar verbundenen, sich horizontal erstreckenden Bandplatte (21) besteht, und dass durch einen horizontal verlaufenden Schenkel der Trägerplatte (20) ein Auflageanschlag (30) für die vom Gehäusebasisteil (6) vertikal nach oben abhebbare Gehäusekappe (7) gebildet wird und ein mit einem horizontalen Schenkel (12) als Verriegelungsanschlag dienender Anschlagwinkel (13) mit dem nach unten ragenden Schenkel (24) der Trägerplatte (20) zerstörungsfrei unlösbar verbunden ist.

5. Vorrichtung nach Anspruch 3, dadurch gekennzeichnet, dass ein unterer Teil (15a) des Bandzapfens (15) durch einen diesen von der Zarge (2) distanzierenden Zapfenschuh (28) mit der Zarge (2) zerstörungsfrei unlösbar verbunden ist und ein mit dieser zerstörungsfrei unlösbar verbundenes Kabeldurchführungsrohr (27) die Zargenvorderwand (2a), den Zapfenschuh (28) und eine zargenseitige Wandpartie des unteren Bandzapfenteiles (15a) durchsetzt.

6. Vorrichtung nach Anspruch 4, dadurch gekennzeichnet, dass der vertikal nach unten ragende Schenkel (24) der abgewinkelten Trägerplatte (20) mit einer sich horizontal erstreckenden fensterartigen Ausnehmung (25) und der Anschlagwinkel (13) an seinem horizontalen Anschlagwinkel (12) mit Durchgangsöffnungen (26) für die Kabeldurchführung zum Schalter (3) hin versehen sind.

**Claims**

1. Device for checking the closed position of a folding door (1), consisting of a switching device made up of several elements which is partly fitted to the frame (2) and partly to the door and which releases a signal indicating the closed position of the door (1), characterized in that all elements (3, 4, 16, 17, 22, 23) of the switching device are made inaccessible by a common casing (5) which is composed of a casing base (6) undetachably connected to the door (1) and of a casing cap (7) placed in a locking manner on said base (6), whereby said casing cap (7) is locked to the base (6) by means of a safety lock (8) arranged within the casing (5) and detachably and non-destructively joined to the casing cap (7), and is therefore secured against raising from the base (6) by an unauthorized person, and that the base (6) comprises a locking stop (12) covered by the casing cap (7) for the lock bolt (11) equally covered by the base (6) whilst the switch (3) and its actuator (4) only become accessible after having raised the unlocked casing cap (7) from the casing base (6).

2. Device according to Claim 1, in which a part of the switching device is a switching member (4), characterized in that the switching member (4) comprises an eccentric disc provided on a pin (15) connected in undetachable and non-destructive manner with the frame (2), whilst a movable switch part (17) of the switch (3) is provided with a roller (16) which runs on the circumference of the eccentric disc (4) on swinging the door (1).

3. Switching device according to Claim 2, characterized in that the pin (15) forming a pivot bearing (15b) for the casing base (6) passes through a portion of said base (6) which projects over the hinge side of the door (1) and the eccentric disc (4) is detachably and non-destructively fixed to a pin portion (15c) projecting into the case (5), the switch (3) is detachable and non-destructively connected to a lower portion (21) of the casing base (6) and the hollow pin (15) serves at the same time to receive the switch cable which passes out of the inside of the frame (2) and leads it to the switch (3).

4. Switching device according to Claim 1, characterized in that the cross-sectionally substantially U-shaped casing base (6) comprises a carrier plate (20) bent at right angles and a horizontally extending band plate (21) which is non-detachably and non-destructively connected thereto, whilst one horizontal limb of the carrier plate (20) forms a support stop (30) for the casing cap (7) which can be raised vertically upwards from the casing base (6) and a stop bracket (13) whose horizontal limb (12) serves as a locking stop is undetachably and non-destructively connected to the downwardly projecting limb (25) of the carrier plate (20).

5. Switching device according to Claim 3, characterized in that a lower part (15a) of the pin (15) is undetachably and non-destructively connected to the frame (2) by a pin shoe (28) which spaces it from the frame (2) and a cable duct (27) undetachably and non-destructively connected therewith passes through the frame front wall (2a), the pin shoe (28) and a frameside wall portion of the lower pin part (15a).

6. Switching device according to Claim 4, characterized in that the vertical downwardly projecting limb (24) of the bent carrier plate (20) is provided with a horizontally extending window-like recess (25) and the stop bracket (13) is provided on its horizontal stop limb (12) with openings (26) for the passage of the cable to the switch (3).

## Revendications

1. Dispositif pour le contrôle de la fermeture d'une porte à battant (1), se composant d'un dispositif contacteur en plusieurs éléments qui est monté en partie sur le bâti (2) de porte et en partie sur la porte (1) à battant proprement dite, ce dispositif fournissant un signal électrique indiquant la position de fermeture de la porte, appareil caractérisé en ce que toutes les parties (3, 4, 16, 17, 19, 23) du dispositif contacteur peuvent être isolées de façon inaccessible par un carter commun (5) qui se compose d'une socle (6) relié de façon inséparable à la porte (1) et d'un couvercle (7) verrouillable mis en place sur ledit socle, lequel couvercle est verrouillé avec le socle à l'aide d'une serrure de sécurité (8), reliée de l'intérieur, de façon séparable sans destruction, au couvercle (7) de carter, en étant ainsi assuré à l'encontre d'un démontage par rapport au socle par une personne non autorisée, et en ce que le socle de carter (6) comporte une butée de verrouillage (12), recouverte par le couvercle et coopérant avec le verrou de serrure (11), également recouvert par lui, le contacteur et son organe d'actionnement étant accessibles seulement après soulèvement du couvercle (7) déverrouillé par rapport au socle (6) du carter.

2. Dispositif selon la revendication 1, dans lequel une partie du dispositif contacteur est un organe contacteur (4), caractérisé en ce que cet organe contacteur (4) se compose d'un disque excentrique qui est monté sur un tourillon creux (15) relié de façon inséparable sauf avec destruction au bâti (2) de porte et en ce qu'une partie mobile (17) du contacteur (3) est pourvue d'un galet (16) qui, lors du pivotement de la porte (1), roule sur la périphérie du disque excentrique (4).

3. Dispositif selon la revendication 2, caractérisé en ce que le tourillon creux (15) formant un palier de pivotement (15b) pour le socle (6) du carter traverse une partie du socle (6) de carter qui forme une saillie vers l'extérieur par rapport à la face de porte (1) correspondant à la charnière, le disque excentrique (4) est fixé de façon inséparable sans destruction sur une partie du tourillon creux qui pénètre dans le carter, en ce que le contacteur (3) est relié de façon séparable sans destruction avec une partie inférieure (21) du socle (6) de carter et en ce que le tourillon creux (15) sert simultanément à recevoir les câbles de contacteur sortant de l'intérieur du bâti et à les guider jusqu'au contacteur (3).

4. Dispositif selon la revendication 1, caractérisé en ce que le socle (6) de carter, ayant une section droite essentiellement en forme de U, se compose d'une plaque portante (20) coudée à angle droit et d'un panneau (21) s'étendant horizontalement et relié de façon inséparable sauf avec destruction avec ladite plaque, et en ce qu'une butée d'appui (30) pour le couvercle de carter, pouvant être relevée verticalement vers le haut à partir du socle de carter (6), est formée par une branche horizontale de la plaque portante (20), et une cornière d'arrêt (13) servant par son aile horizontale (12) de butée de verrouillage est reliée de façon inséparable sauf avec destruction avec la branche (24) de la plaque portante (20) qui est dirigée vers le bas.

5. Dispositif selon la revendication 3, caractérisé en ce qu'une partie inférieure (15a) du tourillon creux (15) est reliée de façon inséparable sauf avec destruction avec le bâti de porte (1) par l'intermédiaire d'un sabot de tourillon (28) l'éloignant dudit bâti (1) et en ce qu'un tube (27) de passage de câble, relié de façon inséparable sauf avec destruction au sabot, traverse la paroi avant (2a) du bâti, le sabot de tourillon (28) et une partie de paroi de la zone inférieure (15a) du tourillon creux qui est située du côté du bâti.

6. Dispositif selon la revendication 4, caractérisé en ce que la branche (24), dirigée verticalement vers le bas, de la plaque portante (20) coudée est pourvue d'un évidement (25) en forme de fenêtre qui s'étend horizontalement et en ce que la cornière d'arrêt (13) comporte, dans son aile horizontale de butée (12), des ouvertures (26) de passage de câbles aboutissant au contacteur (3).

Fig. 1

Fig. 2

Fig. 3

Fig. 4